# EUROPÄISCHE PATENTSCHRIFT

(11) **EP 3 209 600 B1**
(45) Veröffentlichungstag und Bekanntmachung des Hinweises auf die Patenterteilung: **06.11.2019**
(21) Anmeldenummer: 15771880.0
(22) Anmeldetag: 18.09.2015
(51) Int. Cl.: B81C 1/00

(54) **MIKROELEKTRONISCHE BAUELEMENTANORDNUNG MIT EINER MEHRZAHL VON SUBSTRATEN UND ENTSPRECHENDES HERSTELLUNGSVERFAHREN**
MICROELECTRONIC COMPONENT ASSEMBLY COMPRISING A PLURALITY OF SUBSTRATES, AND CORRESPONDING METHOD OF PRODUCTION
ENSEMBLE COMPOSANT MICROÉLECTRONIQUE DOTÉ D'UNE PLURALITÉ DE SUBSTRATS ET PROCÉDÉ DE FABRICATION CORRESPONDANT

(30) Priorität: 23.10.2014 DE 102014221546
(43) Veröffentlichungstag der Anmeldung: 30.08.2017
(73) Patentinhaber: Robert Bosch GmbH, 70442 Stuttgart (DE)
(72) Erfinder: NEUL, Reinhard, 70567 Stuttgart (DE); OHMS, Torsten, 71665 Vaihingen/Enz-Aurich (DE); HEUCK, Friedjof, 70197 Stuttgart (DE); ANTE, Frederik, 70191 Stuttgart (DE); SCHELLING, Christoph, 70597 Stuttgart (DE); HATTASS, Mirko, 70191 Stuttgart (DE)
(86) Internationale Anmeldenummer: PCT/EP2015/071431
(87) Internationale Veröffentlichungsnummer: WO 2016/062465

(56) Entgegenhaltungen:
- US-A1- 2012 313 235
- US-A1- 2013 181 355
- US-A1- 2014 077 390
- Peter Ramm ET AL: "Fabrication of 3D Integrated Fabrication of 3D Integrated Heterogeneous Systems Heterogeneous Systems", , 14. September 2009 (2009-09-14), XP055231787, Gefunden im Internet: URL:http://nordic.imapseurope.org/pdf/IMAP S_Nordic_Ramm.pdf [gefunden am 2015-11-26]
- Peter Ramm ET AL: "3D System Integration Technologies", MRS Online Proceedings Library, 1. Januar 2003 (2003-01-01), XP055232171, DOI: 10.1557/PROC-766-E5.6 Gefunden im Internet: URL:http://journals.cambridge.org/download .php?file=/OPL/OPL766/S1946427400135249a.p df&code=6991fc9f4bea18f1535dff80e4f96db5 [gefunden am 2015-11-30]
- FORSBERG F ET AL: "Heterogeneous integration technology for combination of different wafer sizes using an expandable handle substrate", IEEE 24TH INTERNATIONAL CONFERENCE ON MICRO ELECTRO MECHANICAL SYSTEMS (MEMS 2011), IEEE, US, 23. Januar 2011 (2011-01-23), Seiten 268-271, XP031982401, DOI: 10.1109/MEMSYS.2011.5734413 ISBN: 978-1-4244-9632-7

## Beschreibung

Die vorliegende Erfindung betrifft eine mikroelektronische Bauelementanordnung mit einer Mehrzahl von Substraten und ein entsprechendes Herstellungsverfahren.

### Stand der Technik

Obwohl auch beliebige mikromechanische Bauelementanordnungen anwendbar sind, werden die vorliegende Erfindung und die ihr zugrundeliegende Problematik anhand von MEMS-Substratanordnungen mit Chips auf Siliziumbasis erläutert.

Aus der DE 10 2010 006 132 A1 ist ein miniaturisiertes elektrisches Bauelement mit einem Stapel aus einem MEMS-Substrat und einem ASIC-Substrat bekannt, wobei das MEMS-Substrat und das ASIC-Substrat übereinander in einem Stapelaufbau angeordnet sind und ein Spalt zwischen dem MEMS-Substrat und dem ASIC-Substrat angeordnet ist.

Die DE 10 2008 043 735 A1 beschreibt eine Anordnung von mindestens zwei Wafern mit einer Bondverbindung und ein entsprechendes Herstellungsverfahren.

Die DE 10 2007 048 604 A1 beschreibt einen Verbund aus mindestens zwei Halbleitersubstraten sowie ein entsprechendes Herstellungsverfahren, wobei eine Aluminium enthaltende Schicht auf einem ersten Substrat und eine Germanium enthaltende Schicht auf einem zweiten Substrat als Bondschichten vorgesehen werden.

Üblicherweise werden zum Bilden von mikromechanischen oder mikroelektronischen Bauelementanordnungen mit mehreren Freiheitsgraden Substrate verschiedener MEMS-Funktionalität auf einem Schaltungssubstrat gestapelt. Mittlerweile ist die notwendige ASIC-Schaltungsfläche größenbestimmend für die Bauelemente. Eine weitere Miniaturisierung gestaltet sich dabei als schwierig, da für die dabei verwendeten In "Fabrication of 3D Integrated Heterogeneous Systems" (Ramm et al. 14. September 2009, XP055231787) ist eine 3D MEMS/IC Integration für miniaturisierte Reifendruckkontrollsysteme (TPMS) gezeigt. Dieses System umfasst einen auf ein Transceiver-ASIC gebondeten MEMS-Drucksensor. Das Transceiver-ASIC wiederum ist auf einen Microcontroller gebondet.

Aus US 2013/181355 A1 ist ein Verfahren zur Herstellung von MEMS-Bauelementen bekannt, wobei eine MEMS-Struktur über einem ersten Substrat gebildet wird und die MEMS-Struktur auf ein zweites Substrat gebondet wird.

Die US 2017/077390 A1 offenbart eine elektronische Vorrichtung mit gestapelten Chips.

Die US 2012/313235 A1 offenbart ein Verfahren zur Integration einer MEMS-Struktur in ein Gehäuse.

Wafer/Wafer-Bondprozesse gleiche Wafergrößen und gleichzeitig gleiche laterale Abmessungen notwendig sind.

### Offenbarung der Erfindung

Die vorliegende Erfindung schafft eine mikroelektronische Bauelementanordnung mit einer Mehrzahl von Substraten nach Anspruch 1 und ein entsprechendes Herstellungsverfahren nach Anspruch 9.

Bevorzugte Weiterbildungen sind Gegenstand der jeweiligen Unteransprüche.

### Vorteile der Erfindung

Die vorliegende Erfindung ermöglicht es, mittels einer vorteilhaften Partitionierung der Bauelemente eine kostengünstige und kompakte Stapelbauweise für mikroelektronische Bauelementanordnungen mit MEMS-Funktionalität mit mehreren Freiheitsgraden und besonders geringem lateralem Flächenbedarf bereitzustellen.

Die der vorliegenden Erfindung zugrunde liegende Idee besteht darin, Substrate mit unterschiedlichem Integrationsgrad zweckmäßig zu stapeln.

Gemäß einer bevorzugten Weiterbildung weist das zweite Substrat eine analoge Schaltungsanordnung auf.

Gemäß einer weiteren bevorzugten Weiterbildung weist das erste Substrat eine digitale Schaltungsanordnung auf.

Gemäß einer weiteren bevorzugten Weiterbildung weist das erste Substrat eine minimale Strukturgröße von weniger oder gleich 180 nm auf. So läßt sich ein separater hochintegrierter Digitalteil einer Schaltung z.B. in 300mm-Wafertechnologie realisieren.

Gemäß einer weiteren bevorzugten Weiterbildung weist das zweite Substrat eine minimale Strukturgröße von mehr oder gleich 180 nm auf. So läßt sich ein separater Analogteil einer Schaltung z.B. in 200mm-Wafertechnologie realisieren.

Gemäß einer weiteren bevorzugten Weiterbildung weist das dritte Substrat wenigstens ein Inertialbauelement und/oder ein Drucksensorbauelement auf. So lässt sich ein separater Sensorteil einer Schaltung realisieren.

Gemäß einer weiteren bevorzugten Weiterbildung ist ein viertes Substrat, welches als MEMS-Sensorsubstrat mit einem vierten Integrationsgrad ausgebildet ist, auf das erste Substrat gebondet.

Gemäß einer weiteren bevorzugten Weiterbildung weist das vierte Substrat ein Magnetfeldsensorbauelement und/oder ein Mikroprozessorbauelement auf. So läßt sich ein separater weiterer Sensorteil und/oder Auswerteteil einer Schaltung realisieren.

Gemäß einer weiteren bevorzugten Weiterbildung weist das dritte Substrat ein unverkapptes MEMS-Bauelement auf und ist mittels eines hermetisch dichten Bondrahmens auf das zweite Substrat gebondet, wodurch eine Verkappung gebildet ist. Dies erspart eine zusätzliche separate Verkappung des MEMS-Bauelements.

Gemäß einer weiteren bevorzugten Weiterbildung weist das dritte Substrat ein verkapptes MEMS-Bauelement auf. So läßt sich der Sensorteil vor dem Bonden konditionieren.

### Kurze Beschreibung der Zeichnungen

Weitere Merkmale und Vorteile der vorliegenden Erfindung werden nachfolgend anhand von Ausführungsformen mit Bezug auf die Figuren erläutert.

Es zeigen:
- Fig. 1: eine schematische senkrechte Querschnittsansicht zum Erläutern einer mikroelektronischen Bauelementanordnung mit einer Mehrzahl von Substraten gemäß einer Ausführungsform der vorliegenden Erfindung; und
- Fig. 2a),b): schematische senkrechte Querschnittsansichten zum Erläutern eines Herstellungsverfahrens der mikroelektronischen Bauelementanordnung gemäß Fig. 1.

### Ausführungsformen der Erfindung

In den Figuren bezeichnen gleiche Bezugszeichen gleiche bzw. funktionsgleiche Elemente.

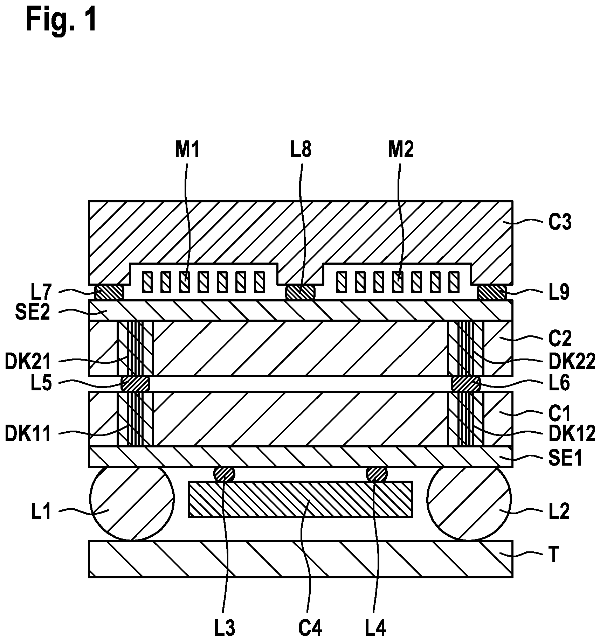

Fig. 1 zeigt eine schematische senkrechte Querschnittsansicht zum Erläutern einer mikroelektronischen Bauelementanordnung mit einer Mehrzahl von Substraten gemäß einer Ausführungsform der vorliegenden Erfindung.

In Fig. 1 bezeichnet Bezugszeichen C1 ein erstes Schaltungssubstrat mit einem ersten Integrationsgrad. Der Integrationsgrad ist dabei ein Maß für die minimale Strukturgröße, welche im vorliegenden Beispiel kleiner oder gleich 180 nm (Nanometer) beträgt. Je höher der Integrationsgrad ist, desto kleiner ist die minimale Strukturgröße.

Insbesondere weist das erste Substrat C1 eine digitale Schaltungsanordnung SE1 auf. Derartige Substrate C1 lassen sich heutzutage in 300 mm-Wafertechnologie herstellen. Das erste Substrat C1 kann mittels Bondverbindungen L1, L2 auf ein Trägerelement T gebondet werden, wobei die digitale Schaltungsanordnung SE1 zum Trägerelement T hin orientiert ist. Des Weiteren weist das erste Substrat C1 Durchkontaktierungen DK11, DK12 auf. Zwischen dem Trägerelement T und der digitalen Schaltungsanordnung SE1 des ersten Substrats C1 ist zudem ein Magnetsensorsubstrat C4 oder alternativ ein Mikroprozessorsubstrat mittels der Bondverbindungen L3, L4 auf das erste Substrat C1 gebondet.

Bezugszeichen C2 bezeichnet ein zweites Schaltungssubstrat mit einem zweiten Integrationsgrad, der vorliegend durch eine minimale Strukturgröße von gleich oder mehr als 180 nm gegeben ist. Das zweite Substrat weist eine analoge Schaltungsanordnung SE2 auf. Das zweite Substrat C2 enthält ebenfalls Durchkontaktierungen DK21, DK22. Es ist mittels Bondverbindungen L5, L6 derart auf das erste Substrat C1 gebondet, dass die Durchkontaktierungen DK21, DK22 mit den Durchkontaktierungen DK11, DK12 in elektrischem und mechanischem Kontakt stehen. Die analoge Schaltungsanordnung SE2 befindet sich auf der vom ersten Substrat C1 abgewandten Seite des zweiten Substrats C2. Das zweite Substrat C2 ist in 200 mm-Wafertechnologie gefertigt.

Auf die analoge Schaltungsanordnung SE2 des zweiten Substrats C2 ist ein MEMS-Sensorsubstrat C3 mittels Bondverbindungen L7, L8, L9 gebondet, welches MEMS-Sensorstrukturen M1, M2 aufweist, beispielsweise eine Inertialsensorstruktur und/oder eine Drucksensorstruktur.

Die Bondverbindungen L7, L8, L9 bilden einen hermetisch dichten Bondrahmen, sodass die MEMS-Sensorelemente M1, M2 jeweils hermetisch dicht verkappt sind.

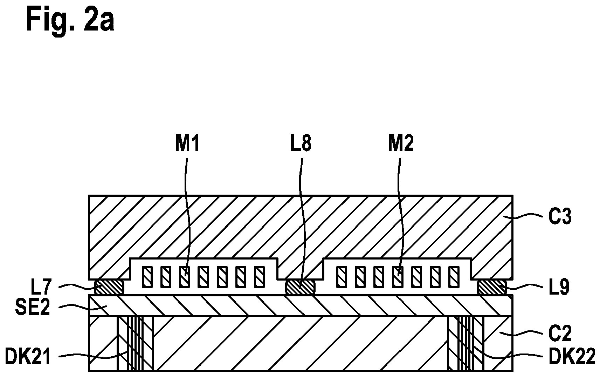

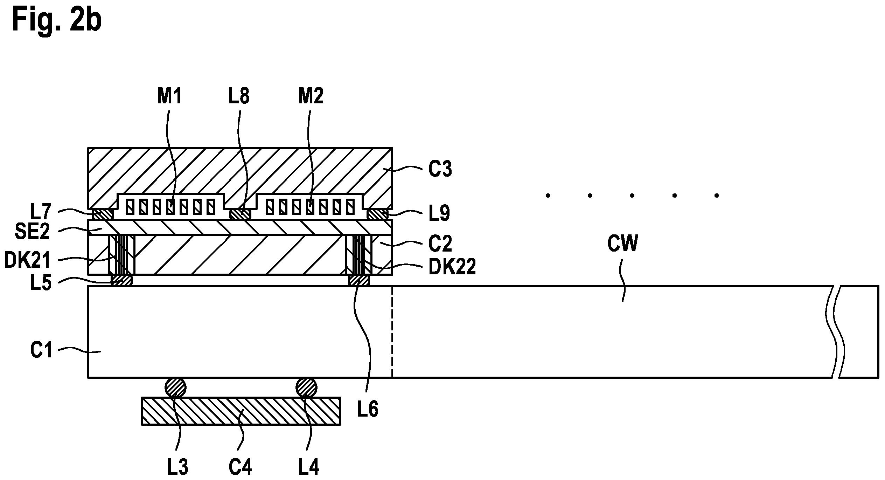

Fig. 2a),b) sind schematische senkrechte Querschnittsansichten zum Erläutern eines Herstellungsverfahrens der mikroelektronischen Bauelementanordnung gemäß Fig. 1.

Zum Herstellen der in Fig. 1 dargestellten mikroelektronischen Bauelementanordnung wird, wie in Fig. 2a), b) dargestellt, zunächst ein Wafer CW mit einer Mehrzahl von wenigstens ersten Substraten C1 bereitgestellt. Der Wafer CW weist einen Durchmesser von 300 mm oder mehr auf.

Weiterhin wird eine Mehrzahl der dritten Substrate C3 auf eine entsprechende Mehrzahl der zweiten Substrate C2 jeweils durch einen Wafer/Wafer-Bondprozess zum Bilden einer entsprechenden Mehrzahl von aufeinandergebondeten Substratpaaren gebondet. Die betreffenden Wafer weisen einen Durchmesser von 200 mm oder weniger auf. Die zweiten und dritten Substrate C2, C3 weisen identische laterale Abmessungen auf.

Nach dem Bilden der Mehrzahl von aufeinandergebondeten Substratpaaren durch einen ersten Bondprozess erfolgt ein Vereinzeln der aufeinandergebondeten Substratpaare.

Die vereinzelten aus einem jeweiligen zweiten und dritten Substrat C2, C3 bestehenden aufeinandergebondeten Substratpaare werden anschließend durch einen Chip/Wafer-Bondprozess auf den Wafer CW mit den ersten Substraten C1 derart gebondet, dass jeweils ein Stapel aus einem ersten Substrat C1, einem zweiten Substrat C2 und einem dritten Substrat C3 in Verbundform vorliegt.

Nach dem Bonden der Mehrzahl von aufeinandergebondeten Substratpaaren auf dem Wafer CW erfolgt ein Vereinzeln der Bondstapel, welche die ersten Substrate C1 und die darauf gebondeten aufeinandergebondeten Substratpaare aus dem zweiten und dritten Substrat C2, C3 aufweisen, z. B. durch einen Sägeprozess.

Durch dieses Herstellungsverfahren ist es möglich, eine mikroelektronische Bauelementanordnung mit mindestens drei übereinander gebondeten Substraten mittels Kombination eines billigeren Wafer/Wafer-Bondprozesses und eines teureren Chip/Wafer-Bondprozesses herzustellen. Durch weiteres mehrfaches Anwenden des beschriebenen Herstellverfahrens als ganzes oder in Teilen lassen sich sogar mikroelektronische Bauelementanordnungen mit mehr als drei aufeinander gebondeten Substraten einfach und kostengünstig realisieren.

Die derart hergestellte mikroelektronische Bauelementanordnung weist neben dem MEMS-Sensorsubstrat C3 ein viertes Substrat C4 auf, in dem erfindungsgemäß ein Magnetfeldsensorbauelement und/oder ein Mikroprozessorbauelement ausgebildet ist.

Das Magnetfeldsensorbauelement C4 wird in einem speziellen Halbleiterprozess hergestellt, der wenig Synergien mit den ASIC- oder MEMS-Prozessen besitzt und in einem Substrat mit unabhängigen lateralen Dimensionen resultiert, und daher werden die vierten Substrate C4 separat hergestellt und ebenfalls in einem Chip/Wafer-Bondprozess auf die digitale Schaltungsanordnung SE1 des jeweiligen ersten Substrats C1 gebondet.

Somit lässt sich insgesamt kostengünstig eine multifunktionale mikroelektronische Bauelementanordnung schaffen.

Obwohl die vorliegende Erfindung anhand bevorzugter Ausführungsbeispiele beschrieben wurde, ist sie darauf nicht beschränkt. Insbesondere sind die genannten Materialien und Topologien nur beispielhaft und nicht auf die erläuterten Beispiele beschränkt.

## Patentansprüche

1. Mikroelektronische Bauelementanordnung mit einer Mehrzahl von Substraten, welche aufweist:
ein erstes Substrat (C1), welches als Schaltungssubstrat mit einem ersten Integrationsgrad ausgebildet ist, wobei der Integrationsgrad ein Maß für die minimale Strukturgröße ist, wobei je höher der Integrationsgrad ist, desto kleiner die minimale Strukturgröße ist;
ein zweites Substrat (C2), welches als Schaltungssubstrat mit einem zweiten Integrationsgrad ausgebildet ist und auf das erste Substrat (C1) gebondet ist;
ein drittes Substrat (C3), welches als MEMS-Sensorsubstrat mit einem dritten Integrationsgrad ausgebildet ist und auf das zweite Substrat (C2) gebondet ist;
wobei der erste Integrationsgrad wesentlich größer als der zweite Integrationsgrad ist,
**dadurch gekennzeichnet, dass**
ein viertes Substrat (C4), welches mit einem vierten Integrationsgrad ausgebildet ist, auf das erste Substrat (C1) gebondet ist, wobei das vierte Substrat (C4) ein Magnetfeldsensorbauelement und/oder ein Mikroprozessorbauelement aufweist.

2. Mikroelektronische Bauelementanordnung nach Anspruch 1, wobei das zweite Substrat (C2) eine analoge Schaltungsanordnung aufweist.

3. Mikroelektronische Bauelementanordnung nach Anspruch 1 oder 2, wobei das erste Substrat (C1) eine digitale Schaltungsanordnung aufweist.

4. Mikroelektronische Bauelementanordnung nach einem der vorhergehenden Ansprüche, wobei das erste Substrat (C1) eine minimale Strukturgröße von weniger oder gleich 180 nm aufweist.

5. Mikroelektronische Bauelementanordnung nach einem der vorhergehenden Ansprüche, wobei das zweite Substrat (C2) eine minimale Strukturgröße von mehr oder gleich 180 nm aufweist.

6. Mikroelektronische Bauelementanordnung nach einem der vorhergehenden Ansprüche, wobei das dritte Substrat (C3) wenigstens ein Inertialbauelement und/oder ein Drucksensorbauelement aufweist.

7. Mikroelektronische Bauelementanordnung nach einem der vorhergehenden Ansprüche, wobei das dritte Substrat (C3) ein unverkapptes MEMS-Bauelement aufweist und mittels eines hermetisch dichten Bondrahmens (L7, L8, L9) auf das zweite Substrat (C2) gebondet ist, wodurch eine Verkappung gebildet ist.

8. Mikroelektronische Bauelementanordnung nach einem der Ansprüche 1 bis 7, wobei das dritte Substrat (C3) ein separat verkapptes MEMS-Bauelement aufweist.

9. Herstellungsverfahren für eine mikroelektronische Bauelementanordnung nach Anspruch 1 mit den Schritten:
Bereitstellen von einem Wafer (CW) mit einer Mehrzahl von den ersten Substraten (C1);
Bonden einer Mehrzahl der dritten Substrate (C3) auf eine entsprechende Mehrzahl der zweiten Substrate (C2) jeweils durch einen Wafer/Wafer-Bondprozess zum Bilden einer entsprechenden Mehrzahl von aufeinandergebondeten Substratpaaren;
Vereinzeln der aufeinandergebondeten Substratpaare;
Bonden der aufeinandergebondeten Substratpaare auf den Wafer (CW) durch einen Chip/Wafer-Bondprozess, so dass die aufeinandergebondeten Substratpaare jeweils auf ein erstes Substrat (C1) des Wafers (CW) gebondet sind; und
Vereinzeln der ersten Substrate (C1) mit den darauf gebondeten aufeinandergebondeten Substratpaaren,
wobei ein viertes Substrat (C4) auf das erste Substrat (C1) gebondet wird.

10. Herstellungsverfahren nach Anspruch 9, wobei die dritten Substrate (C3) gleiche laterale Dimensionen aufweisen wie die zweiten Substrate (C2).

## Claims

1. Microelectronic component assembly comprising a plurality of substrates, which has:
a first substrate (C1), which is designed as a circuit substrate with a first degree of integration, wherein the degree of integration is a measure of the minimum structure size, wherein the higher the degree of integration, the smaller the minimum structure size;
a second substrate (C2), which is designed as a circuit substrate with a second degree of integration and is bonded onto the first substrate (C1);
a third substrate (C3), which is designed as a MEMS sensor substrate with a third degree of integration and is bonded onto the second substrate (C2);
wherein the first degree of integration is substantially greater than the second degree of integration,
**characterized in that**
a fourth substrate (C4), which is designed with a fourth degree of integration, is bonded onto the first substrate (C1), wherein the fourth substrate (C4) has a magnetic field sensor component and/or a microprocessor component.

2. Microelectronic component assembly according to Claim 1, wherein the second substrate (C2) has an analogue circuit assembly.

3. Microelectronic component assembly according to Claim 1 or 2, wherein the first substrate (C1) has a digital circuit assembly.

4. Microelectronic component assembly according to one of the preceding claims, wherein the first substrate (C1) has a minimum structure size of less than or equal to 180 nm.

5. Microelectronic component assembly according to one of the preceding claims, wherein the second substrate (C2) has a minimum structure size of more than or equal to 180 nm.

6. Microelectronic component assembly according to one of the preceding claims, wherein the third substrate (C3) has at least one inertial component and/or a pressure sensor component.

7. Microelectronic component assembly according to one of the preceding claims, wherein the third substrate (C3) has an uncapped MEMS component and is bonded onto the second substrate (C2) by means of a hermetically sealed bond frame (L7, L8, L9), as a result of which a capping is formed.

8. Microelectronic component assembly according to one of Claims 1 to 7, wherein the third substrate (C3) has a separately capped MEMS component.

9. Production method for a microelectronic component assembly according to Claim 1 comprising the steps of:
providing a wafer (CW) with a plurality of the first substrates (C1);
bonding a plurality of the third substrates (C3) to a corresponding plurality of the second substrates (C2) in each case by a wafer/wafer bonding process to form a corresponding plurality of substrate pairs that are bonded onto one another;
separating the substrate pairs that are bonded onto one another;
bonding the substrate pairs that are bonded onto one another onto the wafer (CW) by a chip/wafer bonding process so that the substrate pairs that are bonded onto one another are bonded in each case onto a first substrate (C1) of the wafer (CW); and
separating the first substrates (C1) having the substrate pairs that are bonded onto one another bonded thereon,
wherein a fourth substrate (C4) is bonded onto the first substrate (C1).

10. Production method according to Claim 9, wherein the third substrates (C3) have identical lateral dimensions to the second substrates (C2).

## Revendications

1. Ensemble composant microélectronique doté d'une pluralité de substrats, comprenant :
un premier substrat (C1) qui est conçu comme substrat de circuit avec un premier degré d'intégration, dans lequel le degré d'intégration est une mesure de la taille minimale de la structure, dans lequel plus le degré d'intégration est élevé, plus la taille minimale de la structure est réduite ;
un deuxième substrat (C2) qui est conçu comme substrat de circuit avec un deuxième degré d'intégration et qui est connecté par métallisation sur le premier substrat (C1) ;
un troisième substrat (C3) qui est conçu comme substrat de capteur MEMS avec un troisième degré d'intégration et qui est connecté par métallisation sur le deuxième substrat (C2) ;
dans lequel le premier degré d'intégration est sensiblement supérieur au deuxième degré d'intégration, **caractérisé en ce qu'**un quatrième substrat (C4) qui est conçu avec un quatrième degré d'intégration est connecté par métallisation sur le premier substrat (C1), dans lequel le quatrième substrat (C4) comporte un composant capteur de champ magnétique et/ou un composant microprocesseur.

2. Ensemble composant microélectronique selon la revendication 1, dans lequel le deuxième substrat (C2) comporte un ensemble circuit analogique.

3. Ensemble composant microélectronique selon la revendication 1 ou 2, dans lequel le premier substrat (C1) comporte un ensemble circuit numérique.

4. Ensemble composant microélectronique selon l'une des revendications précédentes, dans lequel le premier substrat (C1) a une taille de structure minimale inférieure ou égale à 180 nm.

5. Ensemble composant microélectronique selon l'une des revendications précédentes, dans lequel le deuxième substrat (C2) a une taille de structure minimale supérieure ou égale à 180 nm.

6. Ensemble composant microélectronique selon l'une des revendications précédentes, dans lequel le troisième substrat (C3) comporte au moins un composant inertiel et/ou un composant capteur de pression.

7. Ensemble composant microélectronique selon l'une des revendications précédentes, dans lequel le troisième substrat (C3) comporte un composant MEMS non encapsulé et est connecté par métallisation sur le deuxième substrat (C2) au moyen d'un cadre de connexion par métallisation (L7, L8, L9) étanche, de manière à former une encapsulation.

8. Ensemble composant microélectronique selon l'une des revendications 1 à 7, dans lequel le troisième substrat (C3) comprend un composant MEMS encapsulé séparément.

9. Procédé de fabrication d'un ensemble composant microélectronique selon la revendication 1, comprenant les étapes suivantes :
fournir une plaquette (CW) dotée d'une pluralité desdits premiers substrats (C1) ;
connecter par métallisation une pluralité desdits troisièmes substrats (C3) sur une pluralité correspondante desdits deuxièmes substrats (C2), respectivement par un procédé de connexion par métallisation plaquette/plaquette afin de former une pluralité correspondante de paires de substrats connectés par métallisation les uns sur les autres ;
séparer les paires de substrats connectés par métallisation les uns sur les autres ;
connecter par métallisation lesdites paires de substrats connectés par métallisation les uns sur les autres sur la plaquette (CW) par un processus de connexion par métallisation puce/plaquette de manière à ce que les paires de substrats connectés par métallisation les uns sur les autres soient respectivement connectés par métallisation sur un premier substrat (C1) de ladite plaquette (CW) ; et
séparer les premiers substrats (C1) sur lesquels les paires de substrats sont connectées par métallisation, dans lequel un quatrième substrat (C4) est connecté par métallisation sur le premier substrat (C1).

10. Procédé de fabrication selon la revendication 9, dans lequel les troisièmes substrats (C3) présentent les mêmes dimensions latérales que les deuxièmes substrats (C2) .
